# EUROPEAN PATENT APPLICATION

(11) **EP 4 415 507 A1**
(43) Date of publication of application: **14.08.2024**
(21) Application number: 24154881.7
(22) Date of filing: 31.01.2024
(51) Int. Cl.: H10K 59/35

(54) **LIGHT EMITTING DISPLAY DEVICE**

(30) Priority: 01.02.2023 KR 20230013741
(71) Applicant: Samsung Display Co., Ltd., Yongin-si, Gyeonggi-do 17113 (KR)
(72) Inventor: LEE, Sang Shin, 17113 Giheung-gu, Yongin-si (KR); Kang, Yeonju, 17113 Giheung-gu, Yongin-si (KR); Kim, Sanghoon, 17113 Giheung-gu, Yongin-si (KR); Lee, Yuri, 17113 Giheung-gu, Yongin-si (KR)
(74) Representative: Dr. Weitzel & Partner

(57) **Abstract**

A light-emitting display device according to one or more embodiments includes pixel areas (PA), and pixels respectively positioned in the pixel areas (PA), and respectively including a first pixel (PXa), a second pixel (PXb), and a third pixel (PXc) for displaying respective colors, wherein the third pixel (PXc) includes a first division pixel (PXc1) and a second division pixel (PXc2) spaced in a first diagonal direction (dr1), and configured to display a same color.

## Description

### BACKGROUND

### 1. Field

The present invention relates to a light-emitting display device including a light-emitting diode (LED).

### 2. Description of the Related Art

A light-emitting display device may include light-emitting diodes (LEDs) corresponding to pixels, and may display an image by controlling a luminance of each light-emitting diode (LED). Unlike a light-receiving type of display device, such as liquid crystal displays, the light-emitting display device does not require a light source, such as a backlight, so a thickness and weight may be reduced. In addition, the light-emitting display device has characteristics, such as high luminance, high contrast ratio, high color reproduction, and high reaction speed, so that it may display high-quality images.

Due to these merits, the light-emitting display device is being applied to various electronic devices, such as mobile devices, such as smartphones and tablets, monitors, and televisions, and has been spotlighted as a display device for automobiles.

### SUMMARY

The invention is defined by the independent claims. Embodiments provide a light-emitting display device including pixels having a uniform shape, without being affected even if the pixels are formed by rotating a panel in various directions during a manufacturing process, and without reducing a lifetime and an aperture ratio.

A light-emitting display device according to the invention includes pixel areas, and pixels respectively positioned in the pixel areas, and respectively including a first pixel, a second pixel, and a third pixel for displaying respective colors, wherein the third pixel includes a first division pixel and a second division pixel spaced in a first diagonal direction, and configured to display a same color.

The first pixel and the second pixel may be spaced in a second diagonal direction crossing the first diagonal direction.

Shapes of the first division pixel and the second division pixel may be substantially similar.

Shapes of the first pixel and the second pixel may be substantially similar.

The shapes of the first pixel and the second pixel may be different from the first division pixel.

The shapes of the first pixel, the second pixel, and the first division pixel may be substantially similar.

Shapes of the first pixel and the second pixel may be different.

Shapes of the first division pixel and the second division pixel may be different.

A shape of the second division pixel may be substantially similar to a shape of the first division pixel rotated 90 degrees.

Sizes of the first division pixel and the second division pixel may be substantially similar.

Sizes of the first pixel and the second pixel may be different.

The pixel areas may be respectively quadrangular, and may be repeatedly arranged in a lattice form.

The first division pixel may be adjacent to at least one of the first pixel or the second pixel of an adjacent one of the pixel areas.

The first division pixel may be not adjacent to any other first division pixel or second division pixel in the adjacent one of the pixel areas.

At least one of the first pixel, the second pixel, the first division pixel, or the second division pixel aligned in parallel to a horizontal side or a vertical side of the pixel areas may be not aligned with others of the pixels by being offset in a horizontal direction or in a vertical direction.

The third pixel may be configured to emit green light, wherein one of the first pixel and the second pixel is configured to emit red light, while the other of the first pixel and the second pixel is configured to emit blue light.

The third pixel may be configured to emit red light, wherein one of the first pixel and the second pixel is configured to emit green light, and the other of the first pixel and the second pixel is configured to emit blue light.

The third pixel may be configured to emit blue light, wherein one of the first pixel and the second pixel is configured to emit red light, and the other of the first pixel and the second pixel is configured to emit green light.

Any one of the first pixel, the second pixel, and the third pixel may include a polygonal shape.

Any one of the first pixel, the second pixel, and the third pixel may include a circular or oval shape.

Any one of the first pixel, the second pixel, and the third pixel may include a shape of a figure having inwardly curved sides.

The first division pixel and the second division pixel may me configured to be driven by a same signal.

A light-emitting display device according to another aspect of the invention includes pixel areas, and pixels positioned in the pixel areas, and including a first pixel, a second pixel, and a third pixel for displaying respective colors, wherein the third pixel includes a first division pixel and a second division pixel that are configured to display a same color, and wherein the first division pixel is adjacent to the first pixel in a first direction, and is adjacent to the second pixel in a second direction, while the second division pixel is adjacent to the first pixel in the second direction, and is adjacent to the second pixel in the first direction.

The first division pixel and the second division pixel may be not adjacent to each other in the first direction or in the second direction.

The pixel areas may be configured to be driven separately from each other.

The pixel areas may be arranged in a lattice form along the first direction and the second direction, which is perpendicular to the first direction, wherein the first pixel, the second pixel, the first division pixel, and the second division pixel are arranged along first and second rows parallel to the first direction, wherein the second pixel and the first division pixel are alternately arranged in the first row, wherein the first pixel and the second division pixel are alternately arranged in the second row, and wherein the first division pixel does not overlap the second division pixel in the second direction.

The pixel areas may be quadrangular, wherein only the first division pixel and the second division pixel are arranged in a first diagonal direction of the pixel areas, and wherein only the first pixel and the second pixel are arranged in a second diagonal direction of the pixel areas.

According to embodiments, the light-emitting display device having a pixel arrangement capable of improving productivity by uniformly maintaining the deposition quality regardless of the rotation of the mask used in the manufacture of the light-emitting display devices, and by reducing the probability of color-mixing defects during the fine metal mask deposition process, while increasing the pixel aperture ratio.

### BRIEF DESCRIPTION OF THE DRAWINGS

FIG. 1 is a perspective view schematically showing a light-emitting display device according to one or more embodiments.
FIG. 2 is a cross-sectional view of one pixel of a light-emitting display device according to one or more embodiments.
FIG. 3 is a top plan view showing a pixel arrangement in a light-emitting display device according to one or more embodiments.
FIGS. 4 to 6 are top plan views respectively showing an example of a mask used in a manufacturing of a light-emitting display device according to one or more embodiments.
FIG. 7 is a top plan view showing a pixel arrangement in a light-emitting display device according to a comparative example.
FIG. 8 is a top plan view showing an example of a mask used in manufacturing a light-emitting display device according to a comparative example.
FIGS. 9 to 15 are top plan views respectively showing an arrangement of pixels in a light-emitting display device according to one or more embodiments.

### DETAILED DESCRIPTION

Aspects of some embodiments of the present invention may be understood more readily by reference to the detailed description of embodiments and the accompanying drawings. Hereinafter, embodiments will be described in more detail with reference to the accompanying drawings. The described embodiments, however, may have various modifications and may be embodied in different forms, and should not be construed as being limited to only the illustrated embodiments herein. Further, each of the features of the various embodiments of the present invention may be combined or combined with each other, in part or in whole, and technically various interlocking and driving are possible. Each embodiment may be implemented independently of each other or may be implemented together in an association. The described embodiments are provided as examples so that this invention will be thorough and complete, and will fully convey the aspects of the present invention to those skilled in the art, and it should be understood that the present invention covers all the modifications, equivalents, and replacements within the idea and technical scope of the present invention. Accordingly, processes, elements, and techniques that are not necessary to those having ordinary skill in the art for a complete understanding of the aspects of the present invention may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting.

In the detailed description, for the purposes of explanation, numerous specific details are set forth to provide a thorough understanding of various embodiments. It is apparent, however, that various embodiments may be practiced without these specific details or with one or more equivalent arrangements.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this invention, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present invention. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present invention refers to "one or more embodiments of the present invention."

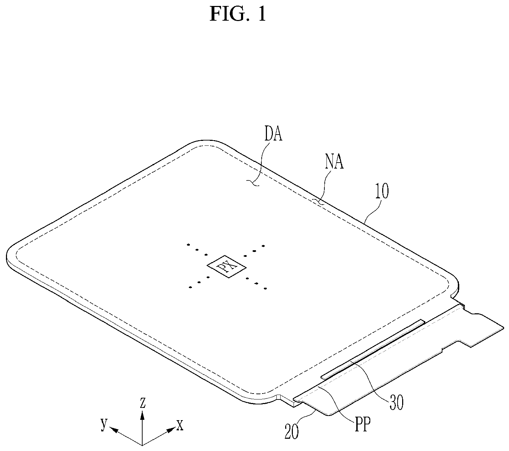

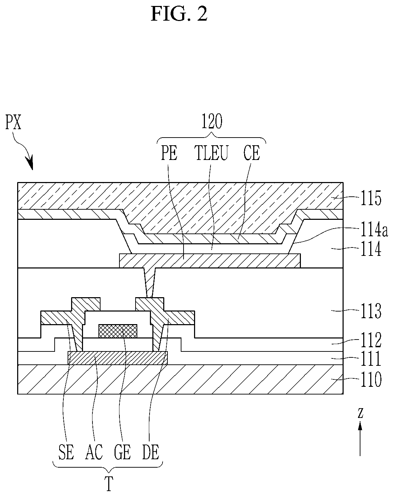

First, a display device according to one or more embodiments is described with reference to FIG. 1 and FIG. 2.

FIG. 1 is a perspective view schematically showing a light-emitting display device according to one or more embodiments. FIG. 2 is a cross-sectional view of one pixel of a light-emitting display device according to one or more embodiments.

Referring to FIG. 1, a light-emitting display device (hereinafter, simply referred to as "a display device") may include a display panel 10, a flexible printed circuit film 20 bonded to the display panel 10, and a driving device including an integrated circuit chip 30. The first direction x, the second direction y, and the third direction z may correspond to a horizontal direction, a vertical direction, and a thickness direction of the display device, respectively.

The display panel 10 may include a display area DA corresponding to a screen on which an image is displayed, and a non-display area NA where circuits and/or signal lines for generating and/or transmitting various signals applied to the display area DA are located. The non-display area NA may surround the display area DA.

In the display area DA of the display panel 10, the pixels PX may be arranged in a matrix. In addition, signal lines, such as a gate line (also referred to as a scan line), a data line, and a driving voltage line may be arranged in the display area DA. Each pixel PX may be connected to the gate line, the data line, the driving voltage line, etc., and may receive a gate signal (also called a scan signal), a data voltage, and a driving voltage (also called a first power voltage or a high potential power voltage) from these signal lines. The pixel PX may be a smallest unit capable of displaying contrast. One pixel PX may correspond to one light-emitting region, and a planar shape of the pixel PX may be defined by the corresponding light-emitting region. Each pixel PX may display any one of primary colors, such as red, green, and blue. The pixel PX may be implemented by a light-emitting element, such as a light-emitting diode (LED) and a pixel circuit connected to the light-emitting element.

A touch sensor for detecting a user's contact and/or non-contact touch may be in the display area DA. Although a display area DA that is generally quadrangular is shown, the display area DA may have various shapes other than quadrangular, such as polygonal, circular, or oval.

In the non-display area NA of the display panel 10, a pad portion PP in which pads for receiving signals from the outside of the display panel 10 are arranged may be positioned. The pad portion PP may be positioned lengthwise in the first direction x along one edge of the display panel 10. The flexible printed circuit film 20 may be bonded to the pad portion PP, and the pads of the flexible printed circuit film 20 may be electrically connected to the pads of the pad portion PP.

A driving unit that generates and/or processes various signals for driving the display panel 10 may be positioned in the non-display area NA of the display panel 10. The driving unit includes a data driver that applies a data voltage to data lines, a gate driver that applies a gate signal to gate lines, and a signal controller that controls the data driver and the gate driver. The pixels PX may receive a data voltage at a timing (e.g., predetermined timing) according to a gate signal generated by a gate driver. The gate driver may be integrated into the display panel 10, and may be positioned on at least one side of the display area DA. The data driver and the signal controller may be provided as an integrated circuit chip (also referred to as a driving IC chip) 30, and the integrated circuit chip 30 may be mounted in the non-display area NA of the display panel 10. The integrated circuit chip 30 may be mounted on a flexible printed circuit film 20 or the like, and may be electrically connected to the display panel 10.

An example of a cross-sectional structure of the display device stacked in the z direction is described with reference to FIG. 2.

The display device may include a display device substrate 110 according to one or more embodiments.

The substrate 110 may include a plastic material, such as a polyimide, or may include glass. The substrate 110 may include a flexible material capable of being bent or folded, and may be single-layered or multi-layered.

In one or more embodiments, a buffer layer including an inorganic insulating material or an organic insulating material may be further positioned on the substrate 110.

A semiconductor AC may be positioned on the substrate 110. The semiconductor AC may include a conduction region and a channel region. The semiconductor AC may include a semiconductor material, such as amorphous silicon, polysilicon, or an oxide semiconductor.

A gate insulating layer 111 may be positioned on the semiconductor AC. The gate insulating layer 111 may have a single-layered or multi-layered structure, and may include an inorganic insulating material.

A gate electrode GE may be positioned on the gate insulating layer 111. The gate electrode GE may overlap the channel region of the semiconductor AC. The gate electrode GE may have a single-layered or a multi-layered structure, and may include a metal material, such as molybdenum (Mo), aluminum (Al), copper (Cu), and/or titanium (Ti).

An interlayer insulating layer 112 may be positioned on the gate electrode GE. The interlayer insulating layer 112 may have a single-layered or multi-layered structure, and may include an inorganic insulating material or an organic insulating material.

A source electrode SE and a drain electrode DE may be positioned on the interlayer insulating layer 112. The source electrode SE and the drain electrode DE may have a single-layered or multi-layered structure, and may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu).

The source electrode SE and the drain electrode DE may be electrically connected to each conductive region of the semiconductor AC through respective holes of the interlayer insulating layer 112 and the gate insulating layer 111.

The semiconductor AC, the gate electrode GE, the source electrode SE, and the drain electrode DE constitute one transistor T.

A passivation layer 113 may be positioned on the source electrode SE and the drain electrode DE. The passivation layer 113 may include organic insulating materials, such as various polymer resins.

A first electrode PE may be positioned on the passivation layer 113. The first electrode PE may have a single-layered or a multi-layered structure, and may include at least one of a metal or a transparent conductive oxide film, such as an IZO, an IGZO, and an ITZO.

The first electrode PE is positioned in each pixel PX, and is separated and insulated from the first electrode PE of the neighboring pixel PX.

The first electrode PE may be electrically connected to the drain electrode DE of the transistor T through the hole of the passivation layer 113. The first electrode PE may receive an output current to be transmitted from the drain electrode DE to a light-emitting unit TLEU.

An insulating layer 114 may be positioned on the passivation layer 113. The insulating layer 114 is also referred to as a bank layer or a pixel-defining layer (PDL), and includes/defines a pixel opening 114a overlapping the first electrode PE. In a plan view of the pixel PX described later, the shape of the pixel PX may be defined by the shape of the pixel opening 114a. The insulating layer 114 may include an organic insulating material, such as a polyimide, a polyamide, an acryl resin, benzocyclobutene, and a phenol resin. According to one or more embodiments, the insulating layer 114 may further include a black color pigment.

The light-emitting unit TLEU may be positioned on the first electrode PE.

The light-emitting unit TLEU includes a plurality of layers. The light-emitting unit TLEU, as shown in FIG. 2, includes a layer positioned within each pixel opening 114a of the insulating layer 114. The light-emitting unit TLEU may include a layer positioned on the upper surface of the insulating layer 114 outside the pixel opening 114a as well as inside the pixel opening 114a.

A second electrode CE may be positioned on the light-emitting unit TLEU. The second electrode CE may include a transparent conductive material, such as an ITO, an IZO, an IGZO, or an ITZO.

The second electrode CE of the plurality of pixels PX may be connected to each other to be electrically connected, and may be formed as one electrode.

The second electrode CE may have a translucent characteristic, and may configure a micro-cavity in which light may reciprocate and resonate, together with the first electrode PE.

The first electrode PE, the light-emitting unit TLEU, and the second electrode CE may constitute a light-emitting diode (LED) 120. One of the first electrode PE and the second electrode CE may function as a cathode, and the other may function as an anode.

Above the light-emitting diode (LED) 120, an encapsulation layer 115 for sealing and protecting the light-emitting diode (LED) 120 may be positioned. According to one or more embodiments, an encapsulation substrate may be positioned instead of the encapsulation layer 115.

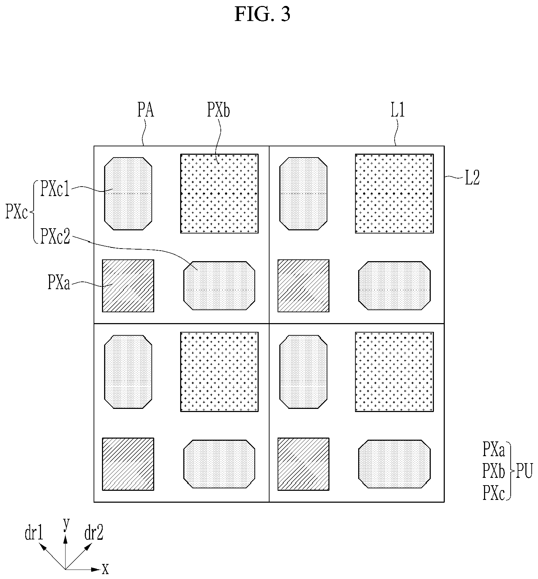

FIG. 3 is a top plan view showing a pixel arrangement in a light-emitting display device according to one or more embodiments.

Referring to FIG. 3, four adjacent pixel areas PA and pixels PXa, PXb, and PXc located in each pixel area PA are shown. The pixel areas PA may be repeatedly located in a first direction x and a second direction y.

The pixels PXa, PXb, and PXc may include a first pixel PXa, a second pixel PXb, and a third pixel PXc. The first pixel PXa, the second pixel PXb, and the third pixel PXc may display different respective colors. For example, one of the first pixel PXa and the second pixel PXb may display red, the other may display green, and the third pixel PXc may display blue. Alternatively, one of the first pixel PXa and the second pixel PXb may display blue, the other may display red, and the third pixel PXc may display green. Alternatively, one of the first pixel PXa and the second pixel PXb may display blue, the other may display green, and the third pixel PXc may display red. The first pixel PXa, the second pixel PXb, and the third pixel PXc positioned in one pixel area PA may constitute a unit pixel PU.

Each quadrangular region defined by the first lines L1 extending in the first direction x, and the second lines L2 extending in the second direction y, may correspond to one pixel area PA. The pixel area PA may be quadrangular with a first width in the first direction x, and a second width in the second direction y. As the pixel density increases, each pixel area PA may be reduced. In another embodiment, the pixel area PA may be rectangular with a first width in the first direction x, and a second width in the second direction y.

The unit pixel PU may be located in each pixel area PA. Therefore, one pixel area PA may correspond to a region in which one unit pixel PU is located. The pixel density may mean the number of the unit pixels PU per inch, in particular per centimeter. The unit pixel PU may consist of the first pixel PXa, the second pixel PXb, and the third pixel PXc. The pixel units PXa, PXb and PXc may have different shapes and/or sizes. In each pixel area PA, at least three pixel circuits for driving the first pixel PXa, the second pixel PXb, and the third pixel PXc may also be located.

The third pixel PXc includes a first division pixel PXc1 and a second division pixel PXc2 positioned to be spaced apart in the first diagonal direction dr1 within the pixel area PA. The first division pixel PXc1 and the second division pixel PXc2 display the emission color of the third pixel PXc. In this way, to display the same color, the first division pixel PXc1 and the second division pixel PXc2 may be driven by the same signal. At this time, the supplied same signal may be supplied while being connected to the same pixel circuit, or the same signal may be supplied while being connected to a separate circuit. Because the first division pixel PXc1 and the second division pixel PXc2 are pixels that display the same color within one unit pixel PU, they may be driven according to the signal of the image to be displayed by the first division pixel PXc1 and the second division pixel PXc2 included in the unit pixel PU. This third pixel PXc may be a pixel for emitting light of any color. That is, as described above, any pixel among the pixels displaying red, blue, and green may be the third pixel PXc, that is, a pixel divided into the first division pixel PXc1 and the second division pixel PXc2, and is not particularly limited.

In the second diagonal direction dr2 crossing the first diagonal direction dr1, the first pixel PXa and the second pixel PXb are positioned apart from each other, in particular spaced apart from each other in the second diagonal direction dr2. Accordingly, the first division pixel PXc1 and the second division pixel PXc2 may be located without being adjacent to each other in the horizontal direction x or the vertical direction y. In addition, in this embodiment, the first division pixel PXc1 is adjacent to the second pixel PXb in the horizontal direction, and is adjacent to the first pixel PXa in the vertical direction. Conversely, the second division pixel PXc2 is adjacent to the first pixel PXa in the horizontal direction, and is adjacent to the second pixel PXb in the vertical direction.

Adjacent may also mean spaced apart from each other. Thus, the first division pixel PXc1 may be spaced apart from the second pixel PXb in the horizontal direction, and may be spaced apart from the first pixel PXa in the vertical direction. Conversely, the second division pixel PXc2 may be spaced apart from the first pixel PXa in the horizontal direction, and may be spaced apart from the second pixel PXb in the vertical direction.

As shown in FIG. 3, in one or more embodiments, the first pixel PXa and the second pixel PXb may have a rectangular shape (e.g., a substantially rectangular shape), and the first division pixel PXc1 and the second division pixel PXc2 may have an octagonal shape (e.g., a substantially octagonal shape). The octagonal shape may be defined by a rectangular shape with cutting edges. Also, the second pixel PXb may be larger than the first pixel PXa. However, the size and shape of the pixels PX are not limited thereto, and may be appropriately selected in consideration of the aperture ratio, the lifetime, etc. along with the color of each pixel positioned in the pixels PX. Also, when the first division pixel PXc1 and the second division pixel PXc2, as shown in FIG. 3, are formed to have a long shape in one direction, it is suitable to have a form in which the length directions of each of the first division pixel PXc1 and the second division pixel PXc2 are perpendicular to each other.

A plurality of pixel areas PA may be repeatedly located in the first direction x and the second direction y. As a result, the pixels PX included in each pixel area PA may be continuously located in the first direction x and the second direction y. For example, as shown in FIG. 3, in the first row of the pixel rows extending in the first direction x, the first division pixel PXc1 and the second pixel PXb are alternately located, and in the second row adjacent to this first row, the first pixel PXa and the second division pixel PXc2 are alternately located. At this time, the first division pixel PXc1 located in the first row is located to not overlap with the second division pixel PXc2 located in the second row with respect to the second direction y. Therefore, in the first column of the pixel array extending in the second direction y, the first division pixel PXc1 and the first pixel PXa are alternately located, and in the second column adjacent to the first column, the second pixel PXb and the second division pixel PXc2 are alternately located. As such, although the pixels PX are continuously arranged, the driving of each pixel PX is independently performed by being distinguished for each unit pixel PU as described above.

In this way, by dividing and locating any one of three color pixels included in the unit pixel PU, all of the pixels PX may have a shape with a small difference in horizontal and vertical ratio. If the shape of the pixels PX has the small difference in horizontal and vertical ratio, it can reduce defects and can improve the aperture ratio when applying a fine metal mask (FMM) used when forming the pixels PX, and when having the same shape of the aperture as the shape of the pixels PX. For example, when forming a medium or larger display panel, there is a case where the fine metal mask may be suitably rotated 90 degrees from an original arrangement direction (a normal arrangement) to another arrangement (a rotation arrangement), even in this case, it is possible to perform deposition with the same quality as the case of applying the normal arrangement without mask deformation.

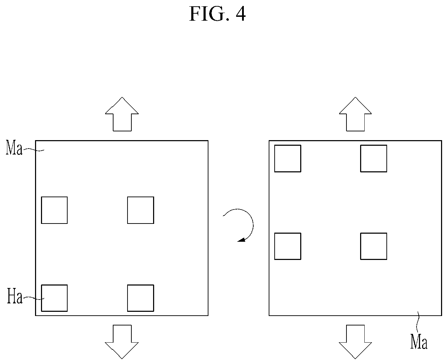

Hereinafter, the above effects will be described in more detail with reference to FIG. 4 to FIG. 8.

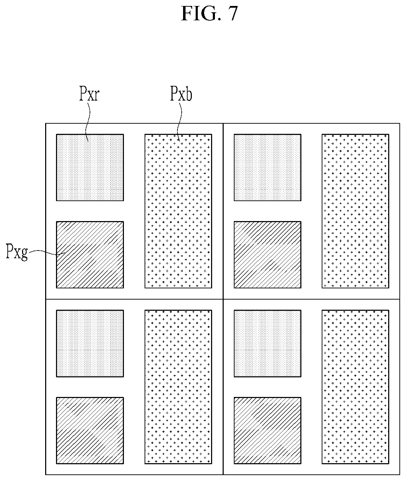

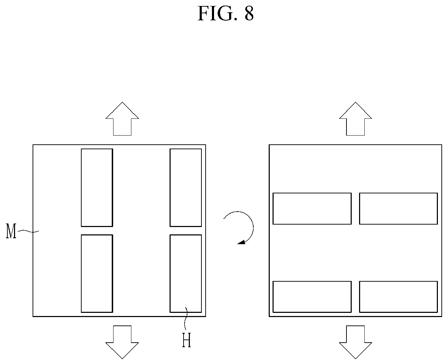

FIG. 4, FIG. 5, and FIG. 6 are a top plan views respectively showing an example of a mask used in manufacturing of a light-emitting display device according to one or more embodiments. FIG. 7 is a top plan view showing a pixel arrangement in a light-emitting display device according to a comparative example. FIG. 8 is a top plan view showing an example of a mask used in manufacturing a light-emitting display device according to a comparative example.

First, FIG. 4 shows the mask Ma used during the deposition of the first pixel PXa of FIG. 3. In the first mask Ma, a plurality of first openings Ha corresponding to the shape of the first pixel PXa are formed. During the deposition, the first mask Ma is pulled in the up and down direction shown in FIG. 4, that is, in the direction of the arrows shown in FIG. 4, and is subjected to a tensile force. However, when the first mask Ma is rotated by 90 degrees as suitable, only the first mask Ma is rotated, and the tensile force is applied equally, so the tensile force in the opposite direction is applied to the first mask Ma based on the initial first mask Ma. Some of the deformation of the opening or the lip between the openings occurs due to the tensile force, as the direction of the tensile force is changed by the rotation, when this deformation occurs in a different direction, the shape of the openings is changed, which may be undesirable. However, as shown in FIG. 4, in the case of the first pixel PXa, the shape and arrangement of the first opening Ha before and after the rotation are substantially the same throughout, so there is no risk due to such a change in the tensile force direction.

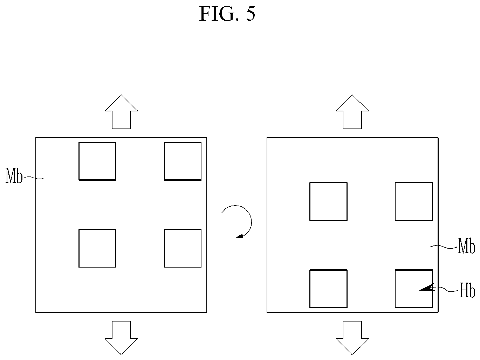

Meanwhile, FIG. 5 shows the second mask Mb used during the deposition of the second pixel PXb in FIG. 3. In the second mask Mb, a plurality of second openings Hb corresponding to the shape of the second pixel PXb are formed. Even in the case of the second mask Mb, when rotating by 90 degrees, as shown in FIG. 5, the shape and arrangement of the second opening Hb are substantially the same before and after the rotation, and the risk due to the change in the tensile force direction does not occur for the second pixel PXb.

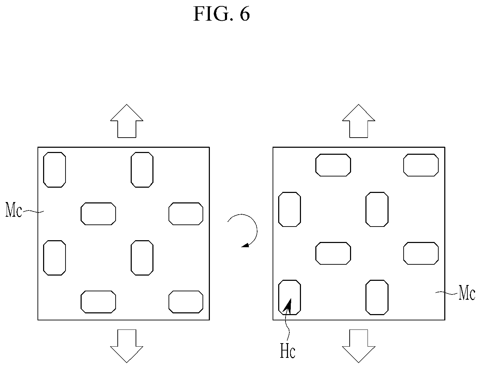

FIG. 6 shows the third mask Mc used in the deposition of the third pixel PXc in FIG. 3. In the third mask Mc, a plurality of third openings Hc corresponding to the shape of the third pixel PXc are formed. Even in the case of the third pixel PXc composed of two division pixels, as shown in FIG. 6, when rotating by 90 degrees, the shape and arrangement of the third opening Hc are substantially the same throughout before and after the rotation, and the risk due to the change in the tensile force direction does not occur for the third pixel PXc.

That is, because the third pixel PXc is composed of two division pixels, which are located in the diagonal direction, the horizontal-to-vertical ratio may be formed to be relatively small, and therefore, because the difference in the width of the mask opening in the direction parallel to the tensile force direction before and after the 90 degree rotation is small, the effect of the tensile force risk may be reduced or minimized.

On the other hand, in the case of the comparative example shown in FIG. 7 and FIG. 8, because at least one of three pixels of R, G, or B has a long shape in one direction, the deposition quality may greatly deteriorate during the rotation due to the above-mentioned tension risk.

FIG. 7 is the top plan view showing the pixel arrangement according to the comparative example. As shown in FIG. 7, the unit pixel includes a red pixel Pxr, a blue pixel Pxb, and a green pixel Pxg, and at this time, the red pixel Pxr and the green pixel Pxg constitute the left column. Also, the blue pixel Pxb is formed lengthwise in the column direction to constitute the right column. This is a general arrangement for securing the aperture ratio while improving the lifetime characteristic in the conventional RGB driving. The blue pixel Pxb may have a size of at least the red pixel Pxr and the green pixel Pxg, in particular the size of the blue pixel Pxb may be greater than that a sum of the size of the red pixel Pxr and the green pixel Pxg.

In this pixel arrangement, a blue mask M for forming the long blue pixel Pxb is shown in FIG. 8. As shown in FIG. 8, the blue mask M has a blue opening H corresponding to the shape of the blue pixel Pxb. The blue opening H is subjected to the tensile force applied parallel to the length direction of the blue opening H as shown on the left before the rotation. In this case, the blue opening H is structurally stable against the deformation because it is wide in the direction parallel to the direction of the tensile force.

On the other hand, after the rotation, as shown on the right, the bule mask M receives the tensile force applied in parallel to the width direction of the blue opening H. In the case of the blue opening H formed lengthwise in the direction perpendicular to the tensile force direction, it may be relatively easy to deform along the tensile force in the width direction. In other words, because of the large difference between the horizontal and vertical ratios, it may be difficult to secure the structural stability against the changes in the tensile force due to the rotation. To complement this, in the structure of FIG. 8, it is possible to reduce the width of the length direction of the blue opening H, however, in this case, the stability will be improved, but there is a limit because it may be difficult to secure the aperture ratio.

On the other hand, as described above, by dividing the pixel of any one color among the pixels PX to be arranged in the diagonal direction, because the difference in the horizontal and vertical ratios may be reduced or minimized for all pixels, the stability may be secured against the change in the tensile force due to the mask rotation.

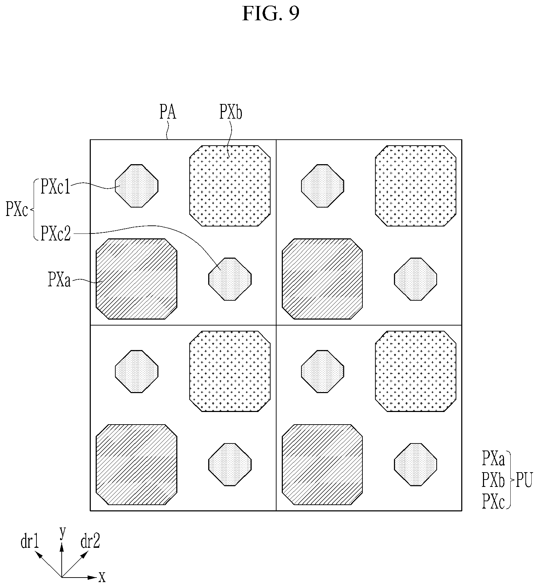

In addition, as the arrangement includes the division pixel, the degree of freedom for the pixel shape and size transformation is higher than that of the comparative example, the aperture ratio may be further improved by properly choosing the color or size of the pixels being subdivided. For example, for a display device with pixel densities of 265 ppi and 254 ppi, in the comparative example designed with the arrangement like FIG. 7, and in Embodiment 1 designed with the arrangement like FIG. 3, and in Embodiment 2 designed with the arrangement like FIG. 9 described later, the aperture ratio of each pixel PXa, PXb, and PXc is as shown in Table 1 below. In this case, in the Embodiment 1, it is designed such that the first pixel PXa is the red pixel, the second pixel PXb is the blue pixel, and the third pixel is the green pixel PXc (e.g., the green pixel is the division pixel), in Embodiment 2, it is designed such that the first pixel PXa is the green pixel, the second pixel PXb is the blue pixel, and the third pixel is the red pixel PXc (e.g., the red pixel is the division pixel).

**Table 1**

| | Pixel density (ppi) | Pixel interval (µm) | Red pixel aperture ratio (%) | Blue pixel aperture ratio (%) | Green pixel aperture ratio (%) |
|---|---|---|---|---|---|
| Comparative Example | 265 | 19.06 | 17.20 | 42.07 | 39.16 |
| Embodiment 1 | | 19.02 | 18.42 | 45.04 | 41.90 |
| Embodiment 2 | | 19.10 | 18.74 | 45.84 | 42.60 |
| Comparative Example | 254 | 19.02 | 18.24 | 44.64 | 41.54 |
| Embodiment 1 | | 19.20 | 18.43 | 45.02 | 41.89 |
| Embodiment 2 | | 19.00 | 19.91 | 48.69 | 45.33 |

As shown in Table 1, for the same pixel density in the display device according to the embodiments, as compared to the display device according to the comparative examples, the aperture ratio of the first pixel PXa and the aperture ratio of the second pixel PXb are both increased, as is the aperture ratio of the division pixel (the green pixel of Embodiment 1 and the red pixel of Embodiment 2). Therefore, the luminance of the pixels PXa, PXb, and PXc may be improved. Also, if the aperture ratio increases, even if the amount of light emitted per unit area of the pixels PXa, PXb, and PXc is reduced, the pixels PXa, PXb, and PXc may provide the same level of luminance, so the lifetime of the pixels PXa, PXb, and PXc may be improved. Meanwhile, the interval between the adjacent pixels PXa, PXb, and PXc corresponds to (e.g., is predetermined in consideration of) the process conditions (e.g., a FMM alignment margin) corresponding to depositing the emission layer of each pixel PXa, PXb, and PXc by using a respective fine metal mask. Therefore, according to the embodiments, the stability against the change in the tensile force due to the mask rotation described above may not only be secured, but it may also contribute to improving the productivity by reducing the probability of color mixture defects during the fine metal mask deposition process while increasing the aperture ratio of the pixels PXa, PXb, and PXc. Hereinafter, various embodiments will be described with reference to FIG. 9 to FIG. 15.

FIG. 9 to FIG. 15 are top plan views respectively showing an arrangement of pixels in a light-emitting display device according to one or more embodiments.

Referring to FIG. 9, compared with the above-described embodiments, there is a difference in the shape and size of the first pixel PXa, the second pixel PXb, and the third pixel PXc. For example, all of the first pixel PXa, the second pixel PXb, and the third pixel PXc may be equally formed as an octagon (e.g., as substantially octagonal). In addition, the first pixel PXa and the second pixel PXb may have the same size, and the third pixel PXc may be smaller. In this case, the first pixel PXa, the second pixel PXb, and the third pixel PXc may be designed to emit light of any color. For example, the third pixel PXc including the first division pixel PXc1 and the second division pixel PXc2 may display any color among red, green, and blue. As such, and as described in the above Embodiment 2, by arranging the first division pixel PXc1 and the second division pixel PXc2 to be spaced apart in the first diagonal direction dr1 of the pixel area PA, and by arranging the first and second pixels PXa and PXb spaced apart in the second diagonal direction dr2, it is possible to improve the aperture ratio and the deposition stability while securing the stability against the change in the tensile force due to the mask rotation.

The first division pixel PXc1 and the second division pixel PXc2 may be rotated 45 degrees or at other orientations with respect to the orientation of the first pixel PXa and/or the second pixel PXb. The first division pixel PXc1 and the second division pixel PXc2 may be smaller than the first pixel PXa and/or the second pixel PXb. The first division pixel PXc1 and the second division pixel PXc2 may be more than four times smaller than the first pixel PXa and/or the second pixel PXb.

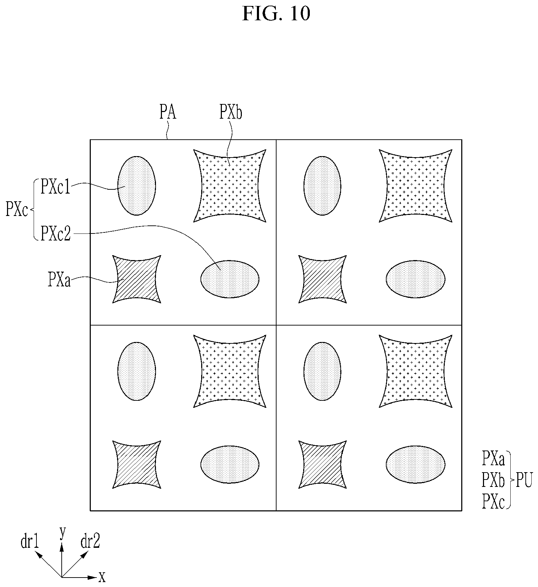

Referring to FIG. 10, compared to the above-described embodiments, in the shape of the first pixel PXa, the second pixel PXb, and the third pixel PXc, there is a difference in that a figure includes a curved line. For example, the first pixel PXa and the second pixel PXb may have a shape including a curved line curved toward the inside of a quadrangle, that is, toward their respective center of the pixel, and the third pixel PXc may have an ellipse shape. At this time, the side of the first pixel PXa or the side of the second pixel PXb facing each of the first division pixel PXc1 and the second division pixel PXc2 may be curved to be substantially complementary to the elliptical shape of the first division pixel PXc1 and/or the second division pixel PXc2, or may be curved separately therefrom. When curved in the complementary shape, the respective distances between the first division pixel PXc1 and the second division pixel PXc2 and the first pixel PXa or the second pixel PXb, may be kept constant. However, it is not limited to as described above, and the respective distances between the first division pixel PXc1 and the second division pixel PXc2 and the first pixel PXa or the second pixel PXb may vary according to positions. Meanwhile, the first pixel PXa, the second pixel PXb, and the third pixel PXc may be designed to emit light of any color.

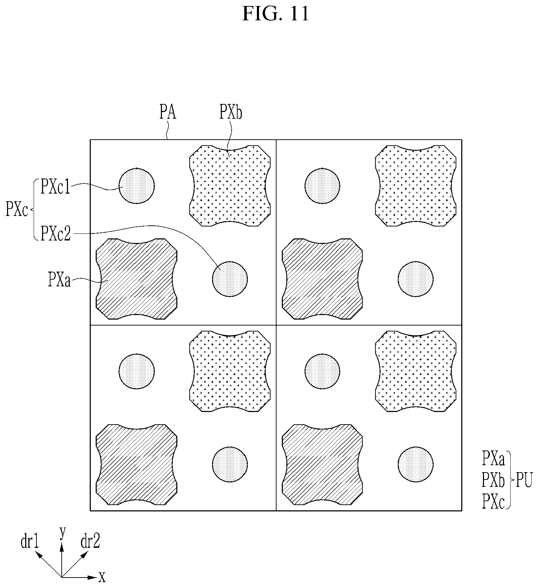

Referring to FIG. 11, compared to the above embodiments, there is a difference in the shapes of the first pixel PXa, the second pixel PXb, and the third pixel PXc. For example, the first pixel PXa and the second pixel PXb may have a shape including a curved line curved inwardly from a shape that is otherwise substantially octagon shaped, that is, toward the center of the respective pixel, while the third pixel PXc may have a circular shape. At this time, the side of the first pixel PXa or the second pixel PXb facing each of the first division pixel PXc1 and the second division pixel PXc2 may be curved to be substantially complementary to the shape of the circle of the first division pixel PXc1 or the second division pixel PXc2, or the sides may respectively be a curved shape separately therefrom. When curved in the complementary shape, the respective intervals between the first division pixel PXc1 and the second division pixel PXc2 and the first pixel PXa or the second pixel PXb, may be maintained constant. However, the embodiments are not limited to as described above, and the respective distances between the first division pixel PXc1 and the second division pixel PXc2 and the first pixel PXa or the second pixel PXb may vary depending on positions. Meanwhile, the first pixel PXa, the second pixel PXb, and the third pixel PXc may be designed to emit light of any color.

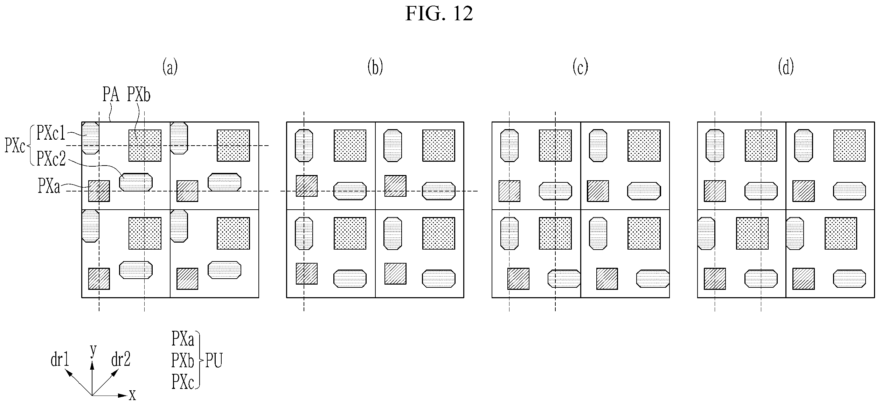

Referring to FIG. 12, the one or more embodiment are different than the above embodiments in that the first pixel PXa, the second pixel PXb, and the third pixel PXc are not arranged to be parallel to the first lines L1 and the second lines L2 of the pixel area PA, and at least some of the first, second, and third pixels PXa, PXb, and PXc are not aligned with the centers of the rest of the pixels, and are offset in the horizontal direction and/or the vertical direction. For example, as shown in FIG. 12 (a), across the entire plurality of pixel areas PA, the first division pixel PXc1 and the second division pixel PXc2 may be offset with respect to the horizontal direction x and the vertical direction y (e.g., shifted to the left in the horizontal direction x, and shifted upward in the vertical direction y). Also, as shown in FIG. 12 (b), over the entire plurality of pixel areas PA, the first pixel PXa may be offset with respect to the horizontal direction x and the vertical direction y (e.g., skewed to the right in the horizontal direction x, and skewed upward in the vertical direction y). Alternatively, as shown in FIG. 12 (c), on only some of the pixel areas PA (e.g., the pixel area positioned at the lower side in the drawing) among the plurality of pixel areas PA, the first pixel PXa and the second division pixel PXc2 may be offset with respect to the horizontal direction (e.g., offset to the right). Also, as shown in FIG. 12 (d), on only some of the pixel areas PA (e.g., the pixel area positioned at the lower side in the drawing) among the plurality of pixel areas PA, the second pixel PXb and the first division pixel PXc1 may be offset with respect to the horizontal direction (e.g., offset to the left in the drawing). However, the above-described configuration is only an example and is not limited thereto, and the centers of the pixels may be offset and located in various combinations.

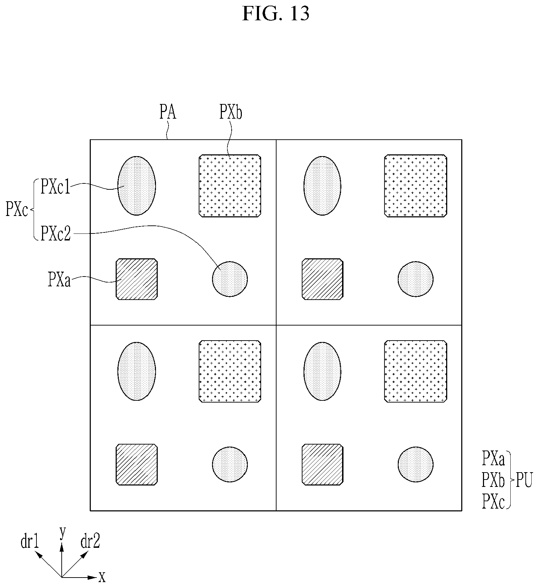

Referring to FIG. 13, compared to the above-described embodiments, the first pixel PXa and the second pixel PXb have the same shape, and there is a difference in that the first division pixel PXc1 and the second division pixel PXc2 included in the third pixel PXc have different shapes. For example, the first pixel PXa and the second pixel PXb may have a quadrangular (or quadrangular with chamfered corners) shape, the first division pixel PXc1 may be elliptical, and the second division pixel PXc2 may be circular. Also, sizes of the first pixel PXa and the second pixel PXb may be different from each other. However, the embodiments are not limited thereto, and the shape and size of each pixel can be variously changed. Also, the first pixel PXa, the second pixel PXb, and the third pixel PXc may be designed to emit light of any color.

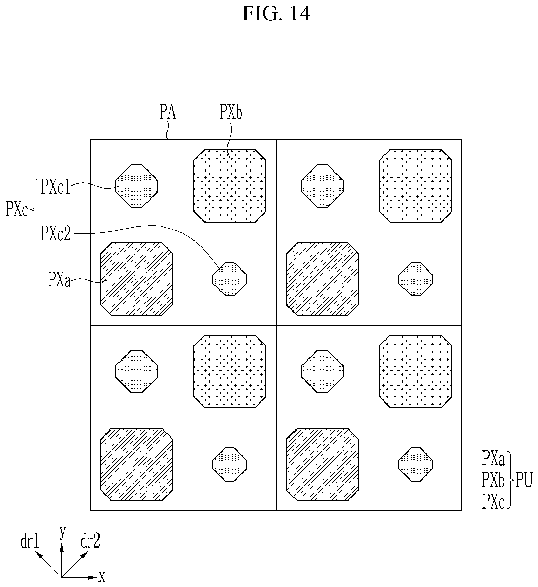

Referring to FIG. 14, compared to the above-described embodiments, there is a difference in that the shapes of the first pixel PXa, the second pixel PXb, and the third pixel PXc are all the same, and only the sizes of the first division pixel PXc1 and the second division pixel PXc2 are different. For example, the first pixel PXa, the second pixel PXb, and the third pixel PXc all have the shape of an octagon, and the first pixel PXa and the second pixel PXb may have the same size. At this time, the size of the first division pixel PXc1 may be larger than the size of the second division pixel PXc2. However, the embodiments are not limited thereto, and the shape and size of each pixel may be variously changed. Also, the first pixel PXa, the second pixel PXb, and the third pixel PXc may be designed to emit light of any color. In addition, the shapes and sizes of the pixels listed above are not limited to one pixel array, and may be mixed and applied, or pixels of other shapes and sizes not illustrated may be applied.

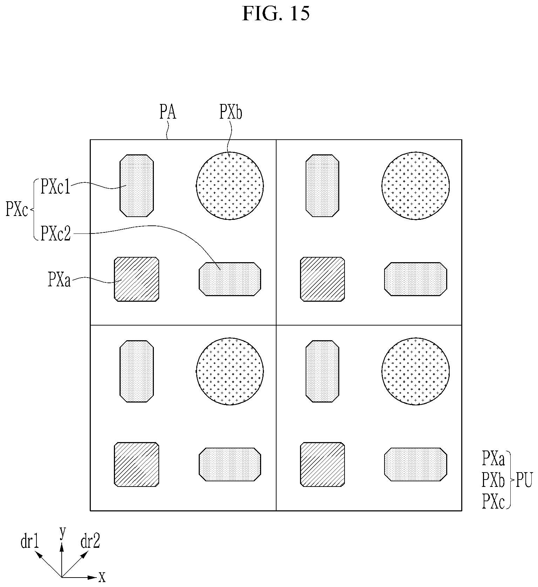

Referring to FIG. 15, compared to the above-mentioned embodiments, there is a difference in that the shapes of the first pixel PXa and the second pixel PXb are different, and the shapes of the first division pixel PXc1 and the second division pixel PXc2 included in the third pixel PXc are the same. For example, the first pixel PXa may have a quadrangular (or quadrangular with chamfered corners) shape, the second pixel PXb may have a circular shape, and the first division pixel PXc1 and the second division pixel PXc2 may have an octagonal shape with a long axis. However, the embodiments are not limited thereto, and the shape and size of each pixel may be variously changed. Also, the first pixel PXa, the second pixel PXb, and the third pixel PXc may be designed to emit light of any color.

While the present invention has been described in connection with what is presently considered to be practical embodiments, it is to be understood that the present invention is not limited to the disclosed embodiments.

### Description of Some of the Reference Characters

| | | | | | |
|---|---|---|---|---|---|
| 10: | display panel | DA: | display area | PA: | pixel area |
| PU: | unit pixel | PX: | pixel | PXa: | first pixel |
| PXb: | second pixel | PXc: | third pixel | PXc1: | first division pixel |
| PXc2: | second division pixel | | | | |

## Claims

1. A light-emitting display device comprising:
pixel areas (PA); and
pixels (PX) respectively positioned in the pixel areas (PA), and respectively comprising a first pixel (PXa), a second pixel (PXb), and a third pixel (PXc) for displaying respective colors,
wherein the third pixel (PXc) comprises a first division pixel (PXc1) and a second division pixel (PXc2) spaced in a first diagonal direction (dr1), and configured to display a same color.

2. The light-emitting display device of claim 1, wherein the first pixel (PXa) and the second pixel (PXb) are spaced in a second diagonal direction (dr2) crossing the first diagonal direction (dr1).

3. The light-emitting display device of claim 1 or 2, wherein shapes of the first division pixel (PXc1) and the second division pixel (PXc2) are substantially similar.

4. The light-emitting display device of at least one of claims 1 to 3, wherein shapes of the first pixel (PXa) and the second pixel (PXb) are substantially similar.

5. The light-emitting display device of at least one of claims 1 to 4, wherein the shapes of the first pixel (PXa) and the second pixel (PXb) are different from the first division pixel (PXc1).

6. The light-emitting display device of at least one of claims 1 to 4, wherein the shapes of the first pixel (PXa), the second pixel (PXb), and the first division pixel (PXc1) are substantially similar.

7. The light-emitting display device of at least one of claims 1 to 3, wherein shapes of the first pixel (PXa) and the second pixel (PXb) are different.

8. The light-emitting display device of at least one of claims 1, 2 or 4 to 7, wherein shapes of the first division pixel (PXc1) and the second division pixel (PXc2) are different.

9. The light-emitting display device of at least one of claims 1, 2 or 4 to 7, wherein a shape of the second division pixel (PXc2) is substantially similar to a shape of the first division pixel (PXc1) rotated 90 degrees.

10. The light-emitting display device of at least one of claims 1 to 9, wherein sizes of the first division pixel (PXc1) and the second division pixel (PXc2) are substantially similar.

11. The light-emitting display device of at least one of claims 1 to 10, wherein sizes of the first pixel (PXa) and the second pixel (PXb) are different.

12. The light-emitting display device of at least one of claims 1 to 11, wherein the pixel areas (PA) are respectively quadrangular, and are repeatedly arranged in a lattice form.

13. The light-emitting display device of at least one of claims 1 to 12, wherein the first division pixel (PXc1) is adjacent to at least one of the first pixel (PXa) or the second pixel (PXb) of an adjacent one of the pixel areas (PA).

14. The light-emitting display device of at least one of claims 1 to 13, wherein the first division pixel (PXc1) is not adjacent to any other first division pixel (PXc1) or second division pixel (PXc2) in the adjacent one of the pixel areas (PA).

15. The light-emitting display device of at least one of claims 1 to 12, wherein at least one of the first pixel (PXa), the second pixel (PXb), the first division pixel (PXc1), or the second division pixel (PXc2) aligned in parallel to a horizontal side or a vertical side of the pixel areas (PA) is not aligned with others of the pixels (PX) by being offset in a horizontal direction or in a vertical direction.

16. The light-emitting display device of at least one of claims 1 to 15, wherein the third pixel (PXc) is configured to emit green light, and
wherein one of the first pixel (PXa) and the second pixel (PXb) is configured to emit red light, while the other of the first pixel (PXa) and the second pixel (PXb) is configured to emit blue light.

17. The light-emitting display device of at least one of claims 1 to 15, wherein the third pixel (PXc) is configured to emit red light, and
wherein one of the first pixel (PXa) and the second pixel (PXb) is configured to emit green light, and the other of the first pixel (PXa) and the second pixel (PXb) is configured to emit blue light.

18. The light-emitting display device of at least one of claims 1 to 15, wherein the third pixel (PXc) is configured to emit blue light, and
wherein one of the first pixel (PXa) and the second pixel (PXb) is configured to emit red light, and the other of the first pixel (PXa) and the second pixel (PXb) is configured to emit green light.

19. The light-emitting display device of at least one of claims 1 to 18, wherein any one of the first pixel (PXa), the second pixel (PXb), and the third pixel (PXc) comprises a polygonal shape.

20. The light-emitting display device of at least one of claims 1 to 19, wherein any one of the first pixel (PXa), the second pixel (PXb), and the third pixel (PXc) comprises a circular or oval shape.

21. The light-emitting display device of at least one of claims 1 to 20, wherein any one of the first pixel (PXa), the second pixel (PXb), and the third pixel (PXc) comprises a shape of a figure having inwardly curved sides.

22. The light-emitting display device of at least one of claims 1 to 21, wherein the first division pixel (PXc1) and the second division pixel (PXc2) are configured to be driven by a same signal.

23. A light-emitting display device comprising:
pixel areas (PA); and
pixels (PX) positioned in the pixel areas (PA), and comprising a first pixel (PXa), a second pixel (PXb), and a third pixel (PXc) for displaying respective colors,
wherein the third pixel (PXc) comprises a first division pixel (PXc1) and a second division pixel (PXc2) that are configured to display a same color, and
wherein the first division pixel (PXc1) is adjacent to the first pixel (PXa) in a first direction (x), and is adjacent to the second pixel (PXb) in a second direction (y), while the second division pixel (PXc2) is adjacent to the first pixel (PXa) in the second direction (y), and is adjacent to the second pixel (PXb) in the first direction (x).

24. The light-emitting display device of claim 23, wherein the first division pixel (PXc1) and the second division pixel (PXc2) are not adjacent to each other in the first direction (x) or in the second direction (y).

25. The light-emitting display device of claim 23 or 24, wherein the pixel areas (PA) are configured to be driven separately from each other.

26. The light-emitting display device of at least one of claims 23 to 25, wherein the pixel areas (PA) are arranged in a lattice form along the first direction (x) and the second direction (y), which is perpendicular to the first direction (x),
wherein the first pixel (PXa), the second pixel (PXb), the first division pixel (PXc1), and the second division pixel (PXc2) are arranged along first and second rows parallel to the first direction (x),
wherein the second pixel (PXb) and the first division pixel (PXc1) are alternately arranged in the first row,
wherein the first pixel (PXa) and the second division pixel (PXc2) are alternately arranged in the second row, and
wherein the first division pixel (PXc1) does not overlap the second division pixel (PXc2) in the second direction (y).

27. The light-emitting display device of at least one of claims 23 to 26, wherein the pixel areas (PA) are quadrangular,
wherein only the first division pixel (PXc1) and the second division pixel (PXc2) are arranged in a first diagonal direction (dr1) of the pixel areas (PA), and
wherein only the first pixel (PXa) and the second pixel (PXb) are arranged in a second diagonal direction (dr2) of the pixel areas (PA).
